# EUROPEAN PATENT SPECIFICATION

(11) **EP 2 220 691 B1**
(45) Date of publication and mention of the grant of the patent: **02.01.2019**
(21) Application number: 08858171.5
(22) Date of filing: 30.09.2008
(51) Int. Cl.: H01L 31/042

(54) **BUSBAR CONNECTION CONFIGURATION TO ACCOMMODATE FOR CELL MISALIGNMENT**
BUSBAR-VERBINDUNGSKONFIGURATION ZUR BERÜCKSICHTIGUNG VON ZELLENFEHLAUSRICHTUNG
CONFIGURATION DE CONNEXION PAR BARRE OMNIBUS DESTINÉE À S'ADAPTER À UN DÉFAUT D'ALIGNEMENT DE CELLULES

(30) Priority: 30.11.2007 US 998507
(43) Date of publication of application: 25.08.2010
(73) Proprietor: Sunpower Corporation, San Jose, CA 95134 (US)
(72) Inventor: ROSE, Douglas, Mountain View CA 94043 (US); PHU, Thomas, Alameda CA 94501 (US)
(74) Representative: Grünecker Patent- und Rechtsanwälte PartG mbB
(86) International application number: PCT/US2008/011333
(87) International publication number: WO 2009/073061

(56) References cited:
- JP-A- 2002 359 381
- JP-A- 2004 119 687
- JP-A- 2005 123 445
- JP-A- 2007 281 044
- US-A- 3 340 096
- US-A- 5 667 596
- US-A1- 2005 268 959
- US-A1- 2006 260 673

## Description

### TECHNICAL FIELD

This invention relates to the field of photovoltaic modules and, in particular, to busbar components for photovoltaic modules.

### BACKGROUND

Photovoltaic (PV) cells provide a renewable source of electrical energy. When PV cells are combined in an array such as in a PV module, the electrical energy collected from all of the PV cells can be combined in series and parallel arrangement to provide power with a certain voltage and current. Many recent design and engineering advances have increased the efficiency and functionality of PV modules.

Generally speaking, a solar cell may be fabricated by forming P-type and N-type active diffusion regions in a silicon substrate. Solar radiation impinging on the solar cell creates electrons and holes that migrate to the active diffusion regions, thereby creating voltage differentials between the active diffusion regions. In a back side contact solar cell, both the active diffusion regions and the metal grids coupled to them are on the back side of the solar cell. The metal grids allow an external electrical circuit to be coupled to and be powered by the solar cell. Back side contact solar cells are also disclosed in U.S. Pat. Nos. 5,053,083 and 4,927,770. US 2006/260673 A1 relates to a photovoltaic element having a photovoltaic layer and a transparent electrode.

One area of development focuses on collecting the electrical energy from all of the PV cells in a PV module so that the collected electrical energy can be efficiently transferred to an electrical load connected to the PV system.

### SUMMARY

A photovoltaic module and a method of fabricating a module according to the invention are defined in claims 1 and 11, respectively. Further advantageous embodiments are defined in the dependent claims.

### BRIEF DESCRIPTION OF THE DRAWINGS

Embodiments of the invention are described by way of example with reference to the accompanying drawings, wherein:
Figure 1 illustrates the backside connections of a photovoltaic module;
Figure 2A illustrates a connection of busbar components to photovoltaic cells that are misaligned;
Figure 2B illustrates a busbar tab to cell pad connection;
Figure 3A illustrates placement of busbar components that are connected with a busbar component connection joint to accommodate for misalignment of the cells according to one embodiment of the present invention;
Figure 3B illustrates the electrical connection of a busbar tab to a cell connection pad in accordance with one embodiment of the invention;
Figure 3C illustrates busbar components according to an alternate embodiment of the present invention.
Figures 4A and 4B illustrate exemplary per cell busbar components in accordance with one embodiment of the invention;
Figures 4C illustrates a connection member for connecting the busbar components of Figures 4A and 4B in accordance with one embodiment of the invention;
Figure 4D illustrates connection of the exemplary busbar components of Figures 4A and 4B with the connection member of Figure 4C in accordance with one embodiment of the invention;
Figure 5 illustrates a process of making a photovoltaic module in accordance with one embodiment of the invention.

### DETAILED DESCRIPTION

The following description sets forth numerous specific details such as examples of specific systems, components, methods, and so forth, in order to provide a good understanding of several embodiments of the present invention. It will be apparent to one skilled in the art, however, that at least some embodiments of the present invention may be practiced without these specific details. In other instances, well-known components or methods are not described in detail or are presented in simple block diagram format in order to avoid unnecessarily obscuring the present invention. Thus, the specific details set forth are merely exemplary. Particular implementations may vary from these exemplary details and still be contemplated to be within the spirit and scope of the present invention.

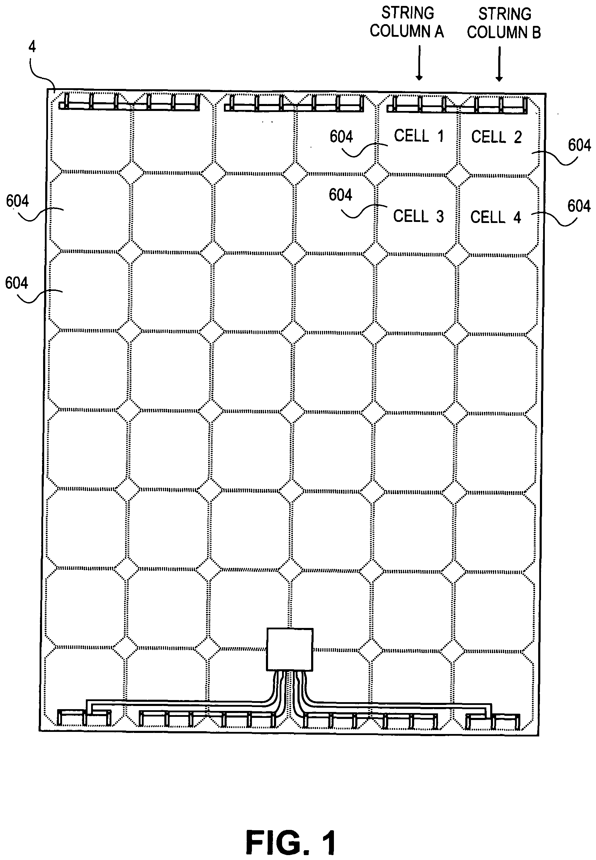

Figure 1 illustrates the back side of a PV module 4, which is not typically seen from the outside of the PV module. Figure 1 also illustrates that the busbar components may be located behind the PV cells (verses adjacent to the cells) to improve the aesthetic look and electrical efficiency of the PV module. The PV cells illustrated in Figure 1 are back contact cells. The PV module 4 includes an array of PV cells connected to one another by busbar components at either end of the module. PV module 4 includes an array of cells 604, which is illustrated as 6 x 8 array in Figure 1. The array of cells are arranged into strings, the strings arranged adjacent one another, for example, six strings of eight cells each are illustrated in Figure 1. It will be appreciated that the number and arrangement of the array of cells may vary from that illustrated. Busbar components couple the strings of cells at each end. For example, busbar component 5 couples string column B (including PV cells 2 and 4) with string column A (including PV cells 1 and 3).

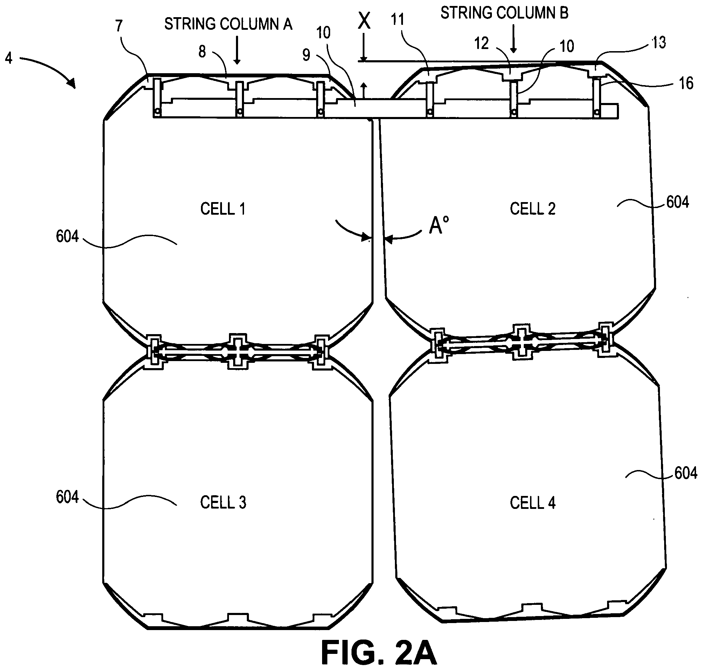

Figure 2A illustrates a more detailed view of an end of module 4 having PV cells that are misaligned. Cells 2 and 4 represent the end cells in string column B of the PV module 4 cell array. Cells 1 and 3 represent the end cells in another string column A of the PV module 4 cell array. The electrical contacts for PV cells to a busbar component are typically solder pads. The tabs on a busbar component may be soldered to the cell connection pads of the PV cell to electrically connect the busbar with the cells. The busbar component 5 that is intended to electrically connect the two cell columns A and B is connected to the cell connection pads 7, 8 and 9 of PV cell 1 and cell connection pads 11, 12 and 13 of PV cell 2. The busbar component 5 is composed of a single piece body 10 having tabs (e.g., tabs 10 and 18) that are joined (e.g., by solder) to respective cell connection pads of each of PV cells 1 and 2. Such an illustrated busbar component may be unable to accommodate stack-tolerance-caused misalignment of cell strings with small cell connection pads.

As shown in Figure 2A, when cell 1 and cells 2 are misaligned (vertically, horizontally and/or rotated), the busbar component 5 is unable to make an electrical connection with all of the pads of each cell and/or may make electrical contact to a region of opposite polarity outside of one or more of the pads. For example, in Figure 2A, cell 2 is offset by a rotation angle of A degrees and distance X from cell 1 creating a misalignment of the busbar component tabs with the pads of cell 2. In particular, busbar connection tab 16 does not make contact with pad 16 of cell 902 at all, and bus tab 10 makes minimal contact with pad 12 of cell 2. An electrical connection between the busbar and the cell outside of the solder pad area can cause electrical shorting or shunting of the cell, resulting in rework and/or yield loss.

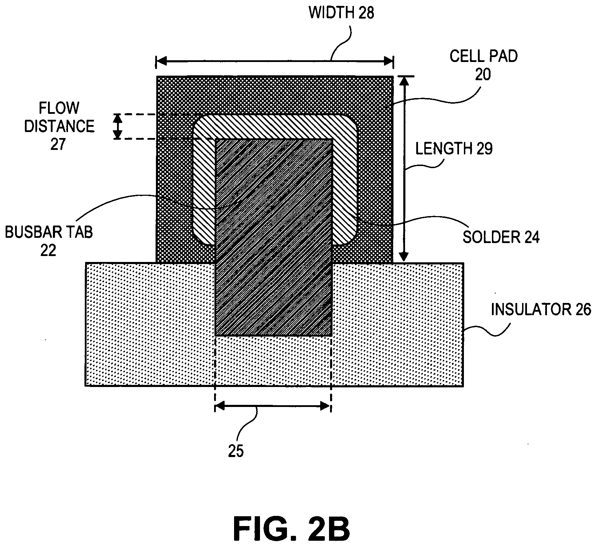

The cell connection pad may, therefore, be sized larger to prevent this deleterious electrical connection. Because the busbars are configured to connect to a plurality of cells, the cell connection pads must be large (e.g., 8mm x 8mm) to compensate for misalignment among the cells. However, large cell connection pads result in cell inefficiency due to voltage-dependent collection in the pad area. In addition, if the misalignment is significant, short outs often result because the busbar tabs make contact with a region of the opposite polarity to the connection pad. The cell connection pad 20 size is also a function of the width 25 of busbar tab 22, the distance 27 of solder 24 flow from the busbar tab 22 and the other misalignment among the bus connection elements (e.g., solder paste, insulator 26 and heating elements), as illustrated in Figure 2B. For robust manufacturing, the distance provided for misalignment is typically at least four times the standard deviation of the misalignment, the standard deviation of the misalignment in any direction being the square root of the sum of the squares other contributions, assuming each contribution to misalignment is independent and normally distributed. The purpose of insulator 26 is to prevent electrical contact of the busbar to regions of the cell with opposite polarity from the connection pads. As described in co-pending patent application serial no. 11/543,440, filed October 3, 2006, the insulator may be part of the cell, a separate piece, or part of the busbar.

Embodiments of the present invention conceived by the inventors, overcome the above noted problems by adding at least one busbar connection joint to a busbar assembly to accommodate for misalignment between cells in a PV array. Busbar components are connectable to one another with a connection point or via a separate busbar connection member (having multiple connection joints) to form a busbar assembly. In one embodiment, pre-assembled busbar components are configured to be aligned and connected to individual cells. The pre-assembled busbar components may be unitarily formed pieces or, alternatively, may be pre-formed by, for example, soldering or welding tabs to the body of the busbar component. Adjacent pre-assembled busbar components can then be connected to one another. Because the pre-assembled busbar components are connected together with at least one busbar connection joint, the coupled string of pre-assembled busbar components can compensate for misalignment by, for example, allowing off linear axis alignment of the busbar components relative to one another about the connection joint.

It will be appreciated that one of skill in the art would expect advantages from using fewer connection joints, as opposed to additional connection joints, as described in the current invention. For example, one of ordinary skill in the art would understand that connection joints are sources of potential physical failure of the busbar. The thickness of these joints also creates stress on the corresponding PV cells, which can break and become useless. For example, the joints can add extra stress on the PV cells during module manufacturing, and the PV cells can crack, which degrades cell performance. Such breakage is frequently at the edges of PV cells because the linear configuration of busbars results in a portion of the busbar extending beyond the edge of the typically cropped corners of the PV cells. In addition, the use of extra connection joints adds steps to the manufacturing process which adds to manufacturing time and costs.

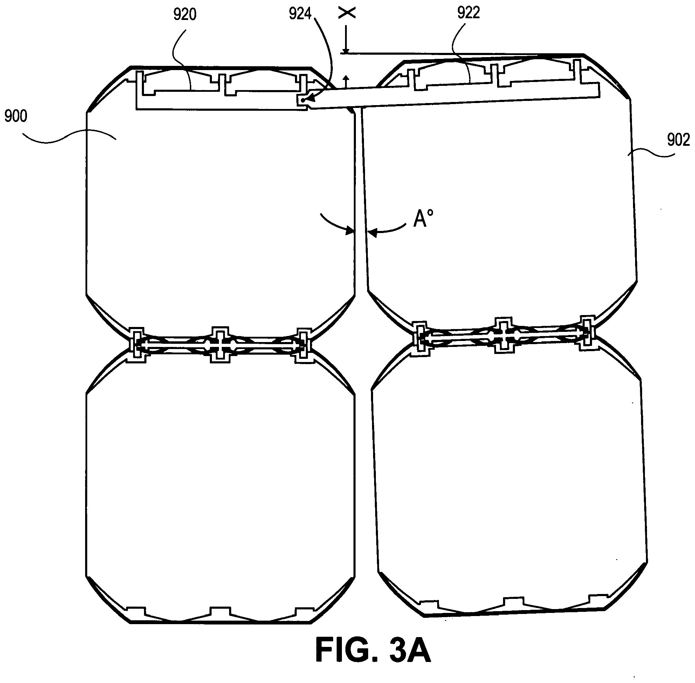

Figure 3A illustrates placement of pre-assembled busbar components that are connected with a busbar connection joint to accommodate for misalignment of the cells, according to one embodiment of the present invention. As shown in Figure 3A, because pre-assembled busbar components 920, 922 are connected to each cell 900, 902 individually, and then coupled to one another, the busbar connection joint 924 connecting the busbar components 920, 922 can act as a pivot point during alignment to accommodate for the misalignment (as shown by distance X and rotation A) of the cells 900, 902.

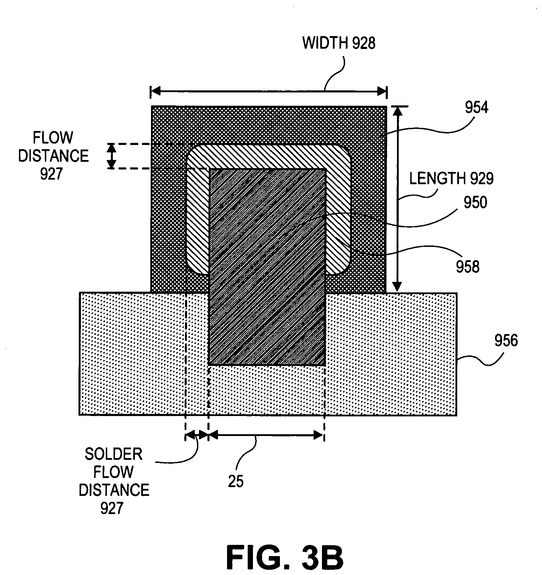

Figure 3B illustrates electrical connection of the busbar tab 950 to the cell pad 954, according to one embodiment of the present invention. The insulator 956 is provided between the busbar tab 950 and the PV cell. As previously noted, the purpose of insulator 956 is to prevent electrical contact of the busbar to regions of the cell with opposite polarity from the connection pads. As described in co-pending patent application serial no. 11/543,440, filed October 3, 2006, published as US9184327, the insulator may be part of the cell, a separate piece, or part of the busbar.

When the bus tab 950 is connected to the cell pad 954, for example by soldering, solder 958 often flows beyond the bus tab 950 and onto the cell pad 954 a distance 927 to make an effective connection. As described above, because the busbar connection joint is provided, the cell pad 954 can be minimized, compared to the previous description relative to Figure 2B and is sized to take into account the busbar tab size (e.g., width 955), the distance 927 of solder flow from the busbar tab 950 and the possible misalignment resulting from the busbar placement tolerance (caused by an imperfection in placement) and the busbar tab tolerance (caused by imperfection in busbar manufacture).

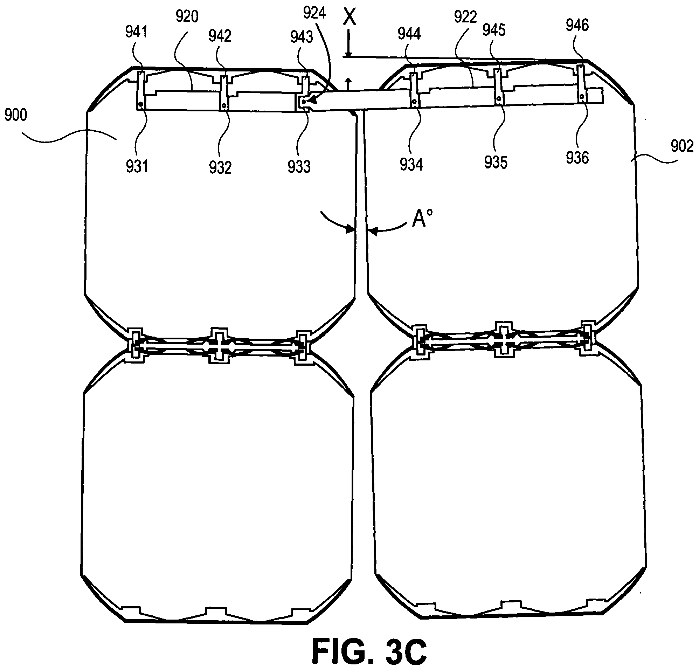

In one embodiment, the pre-assembled busbar components 920 and 922 may be unitary busbar components such that the busbar tabs are unitarily formed with the busbar body, as illustrated in Figure 3A. Alternatively, the busbar components 920 and 922 may be pre-formed busbar components such that the busbar tabs 941-946 are joined (e.g., by soldering) to their respective busbar elongated bodies 920 or 922 at joints 931-936 prior to alignment of the busbar tabs with the cell pads, as illustrated in Figure 3C. It should be noted that the busbar connection joint 924 need not be at a location commensurate with a busbar tab joint as illustrated in the figure but may also be disposed at another location along the busbar component 920 body.

Three tabs are shown with each of the busbar components in Figures 3A and 3C. Nevertheless, it will be appreciated that fewer than three or greater than three tabs may be provided. It will be appreciated that the number of tabs provided on the busbar component depends on the electrical contact requirement of each cell to which the busbar component is to be connected.

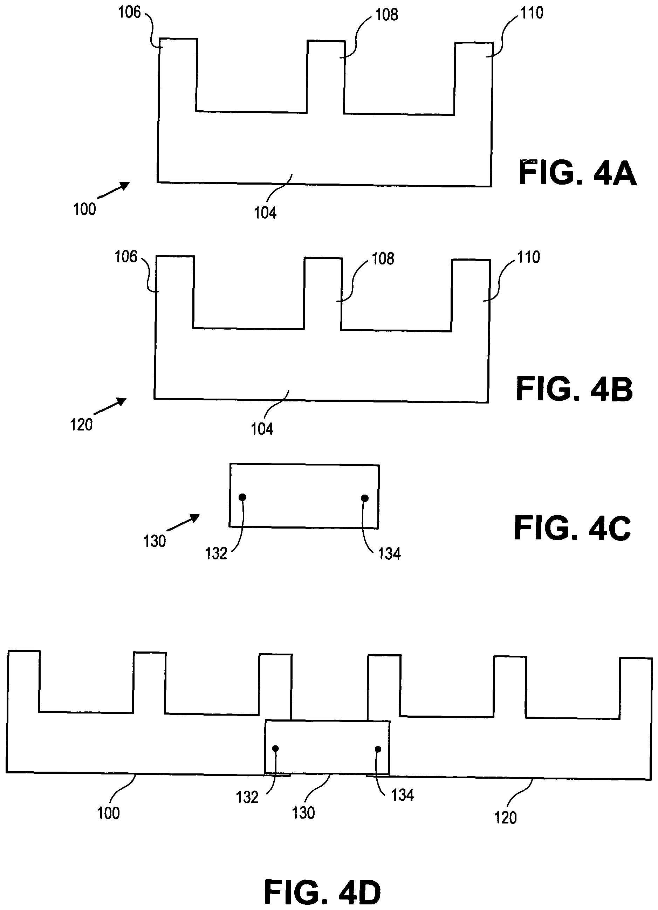

Figures 4A and 4B illustrate a first busbar component 100 and second busbar component 120, respectively, in accordance with an alternative embodiment of the invention. Each busbar component 100, 120 is configured to connect to a photovoltaic (PV) cell of a photovoltaic (PV) module.

Each of the first busbar component 100 and second busbar components 120 includes an elongate body 104, first tab 106, second tab 108, and third tab 110. The tabs 106, 108, 110 are used to electrically connect the busbar components 100, 120 to respective ones of PV cells. The elongate body 104 is used to electrically connect the tabs 106, 108, 110 (and PV cells) to a junction box of the PV module. In one embodiment, the elongate body 104 is an interconnect bus and the tabs 106, 108, 110 are bus tabs.

In one embodiment, the elongate body 104 and tabs 106, 108, 110 of the busbar component are formed as a unitary piece. For example, the busbar components 100, 120 may be formed by stamping a sheet of conductive material. It will be appreciated that the elongate body 103 and tabs 106, 108, 100 can also be formed as separate pieces that are joined together.

The described embodiments of the invention may reduce the solder pad size of the photovoltaic (PV) cells. By adding at least one busbar connection joint to connect the separate busbar components, smaller cell connection pads can be used, thereby increasing cell efficiency and/or decreasing yield loss. In certain embodiments of the invention, the cell connection pad size that only takes into account the busbar tab size (e.g., width 955), the distance 927 of solder flow from the busbar tab 950 and the possible misalignment resulting from the busbar placement tolerance (caused by an imperfection in placement) and the busbar tab tolerance (caused by imperfection in busbar manufacture). This reduced the misalignment distance from about 2.5mm on each side to about 1.5mm on each side. In one particular embodiment, in which the busbar tab width 955 plus solder flow distance 927 is about 3mm, the cell connection pad size (e.g., width 928 and length 929) can be reduced from to about 7mm x 6mm or smaller with the same level of yield loss and rework. It should be noted that alternative embodiments may utilize other shapes, dimensions and sizes for the various elements described herein.

As noted above, it will also be appreciated that one of skill in the art would expect these advantages from using fewer connection joints, as opposed to additional connection joints. Simple analysis of pads in back contact solar cells indicates that the areas under the pads are active on at least one polarity. However, numerical analysis shows that the area under the pads is subject to voltage-dependent collection. The total losses under pads of 8mm x 8mm size on a 149cm² cell with 21% efficiency are approximately 0.57% absolute. The total losses under six pads of 7mm x 6mm size on a 149cm² cell with 21% efficiency are approximately 0.39% absolute. This difference of 0.18% absolute (approximately 0.9% relative) is worth approximately $5.80/module, while the cost imposed by the extra bus-to-bus joins is only approximately $0.20/module.

Three tabs 106, 108, 110 are shown in Figures 4A-4B. Nevertheless, it will be appreciated that fewer than three or greater than three tabs may be provided. It will be appreciated that the number of tabs provided on the busbar component 100, 120 depends on the electrical contact requirement of each cell to which the busbar component is to be connected.

In one embodiment, the elongate body 104 or the tabs 106, 108, 110, or both, may include non-linear portions. For example, the elongate body 104 may have a curved shape along the length of the elongate body 104. Moreover, the elongate body 104 and the tabs 106, 108, 110 may intersect at an angle that is not rectilinear, as illustrated in Figures 4A-4B. For example, one, some or all of the individual tabs 106, 108, 110 may extend away from the elongate body 104 at an angle other than 90 degrees (e.g., 60 degrees). In another example, a tab 110 at the end of the elongate body may be formed as a curvilinear extension of the elongate body 104, so that the elongate body 104 curves approximately 90 degrees to form the tab 110. It will be appreciated that various combinations of rectilinear and curvilinear configurations may be implemented. For example, the tabs 106, 108, 110 may have rounded ends and rounded interior or exterior corners where the tabs 106, 108, 110 intersect the elongate body 104.

In one embodiment, the elongate body 103 may be adapted to have a terminal bus (not shown) connected thereto. In another embodiment, the elongate body 104 may include a unitarily formed extension (not shown), the extension being a terminal bus or a connection to a terminal bus.

Figure 4C illustrates a busbar connection member 130 in accordance with one embodiment of the invention. The illustrated busbar connection member 130 includes a first busbar connection joint 132 and a second busbar connection joint 134. The busbar connection member 130 is configured to connect the first busbar component 100 with the second busbar component 120 at the first busbar connection joint 132 and second busbar connection joint 134, respectively. It will be appreciated that the shape and size of the busbar connection member 130 may vary from that illustrated in Figure 4C. In one embodiment, busbar connection member 130 is formed from the same conductive material as the busbar components 100, 120.

Figure 4D illustrates connection of the first busbar component 100 with the second busbar component 120 with the busbar connection member 130 in accordance with one embodiment of the invention. The first busbar component 100 is connected with the second busbar component 120 by coupling the busbar connection member 130 with the elongate body 104 of each of the first busbar component 100 and the second busbar component 120 at the first connection joint 132 and second connection joint 134, respectively.

In one embodiment, the busbar connection member 130 is connected to the first busbar component 100 and second busbar component 120 by soldering. Alternative joining techniques include, for example, welding, electrically conductive adhesives, mechanical fasteners, or other coupling technologies.

The details for manufacturing the various components may be found in co-pending patent application serial no. 11/543,440, filed October 3, 2006, the contents of which are hereby incorporated by reference.

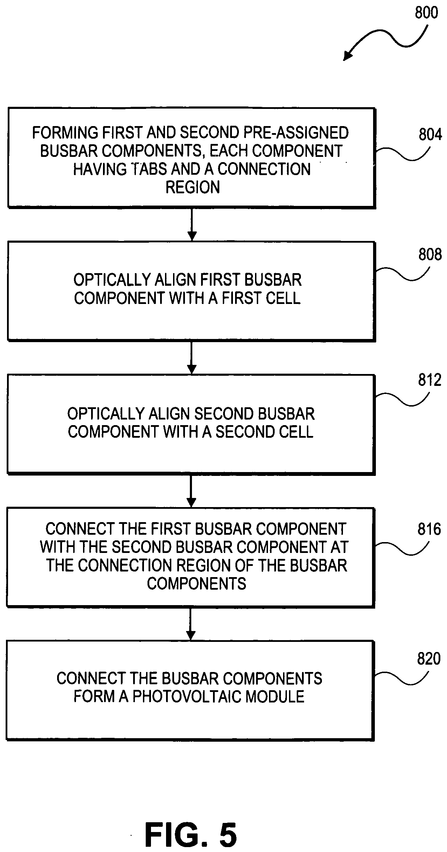

Figure 5 is a flow chart illustrating a method for forming a photovoltaic module in accordance with one embodiment of the invention. The method 800 begins by forming first and second pre-assembled busbar components (block 804). In one embodiment, the pre-assembled busbar components may be formed by as described in the above referenced co-pending patent application.

The method 800 continues by, optionally, optically aligning the first pre-assembled busbar component with a first cell (block 810), and optically aligning the second pre-assembled busbar component with the second cell (block 812). After the pre-assembled busbar components are aligned with the respective cells, the busbar components are connected to the cell by joining the bus tabs with the electrical contacts on the cell. In one embodiment, the bus tabs are soldered with the electrical contacts. It will be appreciated that alternative joining technologies may be used as described hereinabove.

The method 800 continues by connecting the first busbar component with the second busbar component (block 816), as needed. In one embodiment, the first busbar component and second busbar component are joined directly together. In another embodiment, the first busbar component and second busbar component are joined together by an intermediate busbar connection member. In one embodiment, the busbar components are soldered together. It will be appreciated that alternative joining technologies may be used as described hereinabove.

The method 800 continues by connecting an array of cells together using the busbar components to form a photovoltaic module (block 820). In one embodiment, a terminal bus may also connect the busbar components and array of cells with a junction box.

It will be appreciated that the method 800 may vary from that illustrated. For example, the method 800 may include fewer steps or more steps than described above. In another example, the order of the steps may vary from that described above. For example, the method may also include, optionally, aligning first and second insulators with the first and second cells prior to positioning the busbar component.

In one embodiment, busbar components and/or insulators are aligned using a vision system associated with a robot used to position and couple the busbar components to the cells and one another. In one embodiment, the vision system takes an image of the cell, relays the image to a programmer, which using the image, optically aligns the insulators and/or busbar components. The vision system may separately align the insulator and busbar using the same image.

Another exemplary advantage of embodiments of the invention includes individual alignment of a pre-assembled busbar component to a cell, resulting in a reduction of cell short outs.

In the foregoing specification, the invention has been described with reference to specific exemplary embodiments thereof. It will, however, be evident that various modifications and changes may be made thereto without departing from the broader scope of the invention as set forth in the appended claims. The specification and drawings are, accordingly, to be regarded in an illustrative sense rather than a restrictive sense.

## Claims

1. A photovoltaic (PV) module, comprising:
a first back contact PV cell (900);
a first pre-assembled busbar component (920, 100) coupled to the first PV cell at a back side of the first back contact PV cell (900);
a second back contact PV cell (902); and
a second pre-assembled busbar component (922, 120) coupled to the second PV cell at the back side of each of the first and second PV cell, wherein the first preassembled busbar component (920, 100) is coupled with the second pre-assembled busbar component (922, 120) with at least a first connection joint (924, 132, 134),
wherein the first connection joint (924, 132, 134) connects the first pre-assembled busbar component (920, 100) and the second pre-assembled busbar component (922, 120) and acts as a pivot point during alignment to accommodate for the misalignment of the PV cells (900, 902).

2. The module of claim 1, wherein the first pre-assembled busbar component (920, 100) and second pre-assembled busbar component (922, 120) are coupled with the first connection joint with solder.

3. The module of claim 1, wherein at least one of the first and second pre-assembled busbar components is a busbar component formed as a unitary piece.

4. The module of claim 1, wherein at least one of the first and second pre-assembled busbar components is a pre-formed busbar component.

5. The module of claim 1, wherein the first PV cell has a first cell solder pad and the second PV cell has a second cell solder pad, wherein the first pre-assembled busbar has a first elongate body (920, 104) and a first bus tab (941, 106, 108) having a first width and a first tab connection joint (931, 132, 134), wherein the second busbar component has a second elongate body (922, 104) and a second bus tab (944, 106, 108) having a second width and a second tab connection joint (934, 132, 134), and wherein each of the first cell solder pad and the second cell solder pad are sized to accommodate for the first and second widths of the first and second busbar tabs, a solder flow distance, a busbar-placement tolerance and a busbar tab tolerance.

6. The module of claim 5, wherein the first pre-assembled busbar component (920, 100) is formed as a unitary piece and the second pre-assembled busbar component (922, 120) is formed as a unitary piece.

7. The module of claim 1, wherein the first pre-assembled busbar component (920, 100) is aligned with the first cell and the second busbar preassembled component (922, 120) is aligned with the second cell.

8. The module of claim 1, further comprising:
a busbar connection member (130) connected with one of the first or second pre-assembled busbar components (100, 120) with the first connection joint (132) and connected with the other of the first or second pre-assembled busbar (100, 120) components with a second connection joint (134).

9. The module of claim 1, further comprising:
additional PV cells arranged with the first and second PV cells to form a string of PV cells, each of the additional PV cells having a corresponding pre-assembled busbar component coupled to at least one other pre-assembled busbar component in the string of PV cells; and
a plurality of the strings of PV cells arranged to form the PV module.

10. The module of claim 1, wherein the first and second PV cells have cell connections pads respectively coupled to first and second preassembled busbar components, and wherein the cell connection pads have a width and a length being less than 8 millimeters by 8 millimeters.

11. A method of fabricating the back contact photovoltaic (PV) module of claim 1, comprising:
aligning one or more tabs of a first pre-assembled busbar component (920, 100) with a corresponding one or more back side contact pads of a first PV cell;
connecting the one or more tabs of the first pre-assembled busbar component (920, 100) with the corresponding one or more back side contact pads of the first PV cell;
aligning one or more tabs of a second pre-assembled busbar component (922, 120) with a corresponding one or more back side contact pads of a second PV cell;
connecting the one or more tabs of the second pre-assembled busbar component (922, 120) with the corresponding one or more back side contact pads of the second PV cell; and
connecting the first pre-assembled busbar component (929, 100) with the second pre-assembled busbar component (922, 120) using at least one connection joint (924, 132, 134),
wherein the at least one connection joint (924, 132, 134) connects the first pre-assembled busbar component (920, 100) and the second pre-assembled busbar component (922, 120) and acts as a pivot point during alignment to accommodate for the misalignment of the PV cells (900, 902).

12. The method of claim 11, wherein the first pre-assembled busbar component (920, 100) with the second pre-assembled busbar component (922, 120) are connected at the at least one connection joint after the first and second pre-assembled busbars are connected with the first and second PV cells, respectively.

13. The method of claim 11, further comprising connecting the first pre-assembled busbar component (920, 100) and the second pre-assembled busbar component (922, 120) with a busbar connection member, wherein the busbar connection member is connected with one of the first or second preassembled busbar components with the first connection joint and connected with the other of the first or second pre-assembled busbar components with a second connection joint.

## Patentansprüche

1. Photovoltaikmodul (PV-Modul), umfassend:
eine erste Rückkontakt-PV-Zelle (900);
eine erste vormontierte Sammelschienenkomponente (920, 100), die mit der ersten PV-Zelle an einer Rückseite der ersten Rückkontakt-PV-Zelle (900) gekoppelt ist;
eine zweite Rückkontakt-PV-Zelle (902); und
eine zweite vormontierte Sammelschienenkomponente (922, 120), die mit der zweiten PV-Zelle an der Rückseite jeder der ersten und zweiten PV-Zelle gekoppelt ist, wobei die erste vormontierte Sammelschienenkomponente (920, 100) mit der zweiten vormontierten Sammelschienenkomponente (922, 120) über mindestens eine erste Verbindungsstelle (924, 132, 134) gekoppelt ist,
wobei die erste Verbindungsstelle (924, 132, 134) die erste vormontierte Sammelschienenkomponente (920, 100) und die zweite vormontierte Sammelschienenkomponente (922, 120) verbindet und als ein Drehpunkt während der Ausrichtung dient, um eine Fehlausrichtung der PV-Zellen (900, 902) zu berücksichtigen.

2. Modul nach Anspruch 1, wobei die erste vormontierte Sammelschienenkomponente (920, 100) und die zweite vormontierte Sammelschienenkomponente (922, 120) über die erste Verbindungsstelle mit Lot gekoppelt sind.

3. Modul nach Anspruch 1, wobei mindestens eine der ersten und zweiten vormontierten Sammelschienenkomponenten eine Sammelschienenkomponente ist, die als aus einem Teil bestehend ausgebildet ist.

4. Modul nach Anspruch 1, wobei mindestens eine der ersten und zweiten vormontierten Sammelschienenkomponenten eine vorgeformte Sammelschienenkomponente ist.

5. Modul nach Anspruch 1, wobei die erste PV-Zelle eine erste Zelllötkontaktstelle aufweist und die zweite PV-Zelle eine zweite Zelllötkontaktstelle aufweist, wobei die erste vormontierte Sammelschiene einen ersten länglichen Körper (920, 104) und eine erste Sammelschienenlasche (941, 106, 108) mit einer ersten Breite und einer ersten Laschenverbindungsstelle (931, 132, 134) aufweist, wobei die zweite Sammelschienenkomponente einen zweiten länglichen Körper (922, 104) und eine zweite Sammelschienenlasche (944, 106, 108) mit einer zweiten Breite und einer zweiten Laschenverbindungsstelle (934, 132, 134) aufweist, und wobei die erste Zelllötkontaktstelle und die zweite Zelllötkontaktstelle jeweils so bemessen sind, dass sie die erste und die zweite Breite der ersten und zweiten Sammelschienenlaschen, einen Lotflussabstand, eine Sammelschienenplatzierungstoleranz und eine Sammelschienenlaschentoleranz berücksichtigen.

6. Modul nach Anspruch 5, wobei die erste vormontierte Sammelschienenkomponente (920, 100) als ein aus einem Teil bestehend ausgebildet ist und die zweite vormontierte Sammelschienenkomponente (922, 120) als aus einem Teil bestehend ausgebildet ist.

7. Modul nach Anspruch 1, wobei die erste vormontierte Sammelschienenkomponente (920, 100) mit der ersten Zelle ausgerichtet ist und die zweite vormontierte Sammelschienenkomponente (922, 120) mit der zweiten Zelle ausgerichtet ist.

8. Modul nach Anspruch 1, ferner umfassend:
ein Sammelschienenverbindungselement (130), das mit einer der ersten oder zweiten vormontierten Sammelschienenkomponente (100, 120) über die erste Verbindungsstelle (132) verbunden und mit der anderen der ersten oder zweiten vormontierten Sammelschienenkomponente (100, 120) über eine zweite Verbindungsstelle (134) verbunden ist.

9. Modul nach Anspruch 1, ferner umfassend:
zusätzliche PV-Zellen, die mit den ersten und zweiten PV-Zellen angeordnet sind, um einen Strang von PV-Zellen zu bilden, wobei jede der zusätzlichen PV-Zellen eine entsprechende vormontierte Sammelschienenkomponente aufweist, die mit mindestens einer anderen vormontierten Sammelschienenkomponente in dem Strang von PV-Zellen gekoppelt ist; und
eine Vielzahl von PV-Zellensträngen, die angeordnet sind, um das PV-Modul zu bilden.

10. Modul nach Anspruch 1, wobei die erste und die zweite PV-Zelle Zellverbindungskontaktstellen aufweisen, die jeweils mit ersten und zweiten vormontierten Sammelschienenkomponenten gekoppelt sind, und wobei die Zellverbindungskontaktstellen eine Breite und eine Länge von weniger als 8 Millimetern mal 8 Millimetern aufweisen.

11. Verfahren zur Herstellung des Rückkontakt-Photovoltaikmoduls (Rückkontakt-PV-Moduls) nach Anspruch 1, umfassend:
Ausrichten einer oder mehrerer Laschen einer ersten vormontierten Sammelschienenkomponente (920, 100) mit einer entsprechenden einer oder mehreren Rückseitenkontaktstellen einer ersten PV-Zelle;
Verbinden der einen oder mehreren Laschen der ersten vormontierten Sammelschienenkomponente (920, 100) mit der entsprechenden einen oder mehreren Rückseitenkontaktstellen der ersten PV-Zelle;
Ausrichten einer oder mehreren Laschen einer zweiten vormontierten SammelschienenKomponente (922, 120) mit einer entsprechenden einer bzw. mehreren Rückseitenkontaktstellen einer zweiten PV-Zelle;
Verbinden der einen oder mehreren Laschen der zweiten vormontierten Sammelschienenkomponente (922, 120) mit der entsprechenden einen bzw. der mehreren Rückseitenkontaktstellen der zweiten PV-Zelle; und
Verbinden der ersten vormontierten Sammelschienenkomponente (929, 100) mit der zweiten vormontierten Sammelschienenkomponente (922, 120) unter Verwendung von mindestens einer Verbindungsstelle (924, 132, 134),
wobei die mindestens eine Verbindungsstelle (924, 132, 134) die erste vormontierte Sammelschienenkomponente (920, 100) und die zweite vormontierte Sammelschienenkomponente (922, 120) verbindet und als Drehpunkt während der Ausrichtung dient, um die Fehlausrichtung der PV-Zellen (900, 902) zu berücksichtigen.

12. Verfahren nach Anspruch 11, wobei die erste vormontierte Sammelschienenkomponente (920, 100) mit der zweiten vormontierten Sammelschienenkomponente (922, 120) an der mindestens einen Verbindungsstelle verbunden wird, nachdem die erste und zweite vormontierte Sammelschiene mit der ersten bzw. zweiten PV-Zelle verbunden wurde.

13. Verfahren nach Anspruch 11, ferner umfassend das Verbinden der ersten vormontierten Sammelschienenkomponente (920, 100) und der zweiten vormontierten Sammelschienenkomponente (922, 120) über ein Sammelschienenverbindungselement, wobei das Sammelschienenverbindungselement mit einer der ersten oder zweiten vormontierten Sammelschienenkomponente über die erste Verbindungsstelle verbunden ist und mit der anderen der ersten oder zweiten vormontierten Sammelschienenkomponente über eine zweite Verbindungsstelle verbunden wurde.

## Revendications

1. Module photovoltaïque (PV) comprenant :
une première cellule PV à contact arrière (900) ;
un premier composant de barre omnibus pré-assemblé (920, 100) couplé à la première cellule PV sur un côté arrière de la première cellule PV à contact arrière (900) ;
une seconde cellule PV à contact arrière (902) ; et
un second composant de barre omnibus pré-assemblé (922, 120) couplé à la seconde cellule PV sur le côté arrière de chacune des première et seconde cellules PV, dans lequel le premier composant de barre omnibus pré-assemblé (920, 100) est couplé au second composant de barre omnibus pré-assemblé (922, 120) avec au moins un premier joint de raccordement (924, 132, 134),
dans lequel le premier joint de raccordement (924, 132, 134) raccorde le premier composant de barre omnibus pré-assemblé (920, 100) et le second composant de barre omnibus pré-assemblé (922, 120) et agit comme un point de pivotement pendant l'alignement pour s'adapter au mauvais alignement des cellules PV (900, 902).

2. Module selon la revendication 1, dans lequel le premier composant de barre omnibus pré-assemblé (920, 100) et le second composant de barre omnibus pré-assemblé (922, 120) sont couplés au premier joint de raccordement par brasure.

3. Module selon la revendication 1, dans lequel au moins l'un des premier et second composants de barre omnibus pré-assemblés est un composant de barre omnibus formé comme une pièce unitaire.

4. Module selon la revendication 1, dans lequel au moins l'un des premier et second composants de barre omnibus pré-assemblés est un composant de barre omnibus préformé.

5. Module selon la revendication 1, dans lequel la première cellule PV comporte un premier plot de brasure et la seconde cellule PV comporte un second plot de brasure, dans lequel la première barre omnibus pré-assemblée comporte un premier corps allongé (920, 104) et une première languette de bus (941, 106, 108) ayant une première largeur et un premier joint de raccordement de languette (931, 132, 134), dans lequel le second composant de barre omnibus comporte un second corps allongé (922, 104) et une seconde languette de bus (944, 106, 108) ayant une seconde largeur et un second joint de raccordement de languette (934, 132, 134) et dans lequel chacun du plot de brasure de la première cellule et du plot de brasure de la seconde cellule est dimensionnée pour s'adapter aux première et seconde largeurs des première et seconde languettes de bus, à une distance d'écoulement de brasure, à une tolérance de placement de barre omnibus et à une tolérance de languette de barre omnibus.

6. Module selon la revendication 5, dans lequel le premier composant de barre omnibus pré-assemblé (920, 100) est formé comme une pièce unitaire et le second composant de barre omnibus pré-assemblé (922, 120) est formé comme une pièce unitaire.

7. Module selon la revendication 1, dans lequel le premier composant de barre omnibus pré-assemblé (920, 100) est aligné avec la première cellule et le second composant de barre omnibus pré-assemblé (922, 120) est aligné avec la seconde cellule.

8. Module selon la revendication 1, comprenant en outre :
un élément de raccordement de barre omnibus (130) raccordé à l'un des premier et second composants de barre omnibus pré-assemblés (100, 120) avec le premier joint de raccordement (132) et raccordé à l'autre des premier et second composants de barre omnibus pré-assemblés (100, 120) avec un second joint de raccordement (134).

9. Module selon la revendication 1, comprenant en outre :
des cellules PV supplémentaires agencées avec les première et seconde cellules PV pour former une chaîne de cellules PV, chacune des cellules PV supplémentaires ayant un composant de barre omnibus pré-assemblé correspondant couplé à au moins un autre composant de barre omnibus pré-assemblé dans la chaîne de cellules PV ; et
une pluralité des chaînes de cellules PV agencées pour former le module PV.

10. Module selon la revendication 1, dans lequel les première et seconde cellules PV ont des plots de raccordement de cellules respectivement couplés aux premier et second composants de barre omnibus pré-assemblés et dans lequel les plots de raccordement de cellules ont une largeur et une longueur inférieures à 8 millimètres sur 8 millimètres.

11. Procédé de fabrication d'un module photovoltaïque (PV) à contact arrière selon la revendication 1, comprenant :
l'alignement d'une ou plusieurs languettes d'un premier composant de barre omnibus pré-assemblé (920, 100) avec un ou plusieurs plots de contact du côté arrière correspondants d'une première cellule PV ;
le raccordement de la ou des languettes du premier composant de barre omnibus pré-assemblé (920, 100) à la ou aux plots de contact du côté arrière correspondants de la première cellule PV ;
l'alignement d'une ou plusieurs languettes d'un second composant de barre omnibus pré-assemblé (922, 120) avec un ou plusieurs plots de contact du côté arrière correspondants d'une seconde cellule PV ;
le raccordement de la ou des languettes du second composant de barre omnibus pré-assemblé (922, 120) à la ou aux plots de contact du côté arrière correspondants de la seconde cellule PV ; et
le raccordement du premier composant de barre omnibus pré-assemblé (929, 100) au second composant de barre omnibus pré-assemblé (922, 120) en utilisant au moins un joint de raccordement (924, 132, 134),
dans lequel l'au moins un joint de raccordement (924, 132, 134) raccorde le premier composant de barre omnibus pré-assemblé (920, 100) et le second composant de barre omnibus pré-assemblé (922, 120) et agit comme un point de pivotement pendant l'alignement pour s'adapter au mauvais alignement des cellules PV (900, 902).

12. Procédé selon la revendication 11, dans lequel le premier composant de barre omnibus pré-assemblé (920, 100) avec le second composant de barre omnibus pré-assemblé (922, 120) sont raccordés à l'au moins un joint de raccordement après le raccordement des première et seconde barres omnibus pré-assemblées respectivement aux première et seconde cellules PV.

13. Procédé selon la revendication 11, comprenant en outre le raccordement du premier composant de barre omnibus pré-assemblé (920, 100) et du second composant de barre omnibus pré-assemblé (922, 120) à un élément de raccordement de barre omnibus, dans lequel l'élément de raccordement de barre omnibus est raccordé à l'un des premier et second composants de barres omnibus pré-assemblés avec le premier joint de raccordement et raccordé à l'autre des premier et second composants de barres omnibus pré-assemblés avec un second joint de raccordement.
